# EUROPEAN PATENT APPLICATION

(11) **EP 4 411 985 A1**
(43) Date of publication of application: **07.08.2024**
(21) Application number: 22935921.1
(22) Date of filing: 21.12.2022
(51) Int. Cl.: H01Q 7/06, H01Q 1/38, H01Q 1/24, H02J 50/23, H02J 50/00, H02J 50/40, H05K 1/03, H05K 1/18

(54) **ELECTRONIC DEVICE INCLUDING WIRELESS CHARGING ANTENNA AND STRUCTURE THEREOF**

(30) Priority: 31.03.2022 KR 20220040523; 08.06.2022 KR 20220069569
(71) Applicant: Samsung Electronics Co., Ltd., Suwon-si, Gyeonggi-do 16677 (KR)
(72) Inventor: CHOI, Jaejoon, Suwon-si Gyeonggi-do 16677 (KR); KIM, Kyeongmin, Suwon-si Gyeonggi-do 16677 (KR); KIM, Kijung, Suwon-si Gyeonggi-do 16677 (KR); LEE, June, Suwon-si Gyeonggi-do 16677 (KR)
(74) Representative: Gulde & Partner
(86) International application number: PCT/KR2022/020956
(87) International publication number: WO 2023/191251

(57) **Abstract**

An electronic device may include a printed circuit board layer including a plurality of flexible areas and a plurality of rigid areas, a wireless charging circuit disposed in one rigid area among the plurality of rigid areas, and a plurality of wireless charging antennas disposed in the plurality of flexible areas and including a coil shape. The plurality of wireless charging antennas each may be electrically connected in parallel with the wireless charging circuit. Other various embodiments identified through the specification are possible.

## Description

### [TECHNICAL FIELD]

Example embodiments relate to an electronic device including a wireless charging antenna and a structure thereof.

### [BACKGROUND ART]

Wearable electronic device may include electronic devices worn on the user's body, such as watches, glasses, bracelets, or smart rings. Wearable electronic devices are being developed to perform various functions, such as payment through near field communication (NFC) or healthcare functions (e.g., heartrate or oxygen saturation check, as well as functions (e.g., calling or texting) through linking with a portable terminal (e.g., smartphone). As the wearable electronic device perform more and more functions, packing more components in the wearable electronic device is thus required, but is limited due to the reduced space.

A battery may be mounted in the wearable electronic device. The battery may be charged through a separate power supply. The wearable electronic device may receive power from the power supply wirelessly through wireless charging. The battery may be charged when the wearable electronic device is placed properly adjacent to the power supply without connection via a separate charging cable.

Types of wireless charging technology may include magnetic inductive charging, which adopts electromagnetic induction and places the wireless power transmitter (e.g., power supply) and the wireless power receiver (e.g., wearable electronic device or smartphone) adjacent to effective area to charge the battery, and resonance charging, which charges the battery based on the principle of magnetic resonance. Given the fact that the wearable electronic device is a compact device worn on the user's body, magnetic inductive charging is mainly used which may utilize a downsized coil and is relatively less harmful to the human body.

### [DISCLOSURE]

### [TECHNICAL PROBLEM]

A small electronic device (e.g., a smart watch or a smart ring) may include a wireless charging circuit and a wireless charging antenna for wireless charging. A conventional small electronic device may use a wireless charging antenna (a flexible printed circuit board (FPCB) or wireless charging coil including an antenna pattern) together with a printed circuit board (PCB) or FPCB including a wireless charging circuit. The small electronic device is hard to equip with two or more wireless charging antenna due to its limited internal space and thus has a single antenna configuration.

Various example embodiments may provide an electronic device and a structure thereof, to optimize or improve charging efficiency by efficiently designing the structure of the electronic device for wireless charging.

Various example embodiments may provide an electronic device and a structure thereof, to enhance the battery charging efficiency of the electronic device by wirelessly charging the electronic device using a plurality of wireless charging antennas.

### [TECHNICAL PROBLEM]

According to an example embodiment, an electronic device may comprise a printed circuit board layer including a plurality of flexible areas and a plurality of rigid areas, a wireless charging circuit disposed in one rigid area among the plurality of rigid areas, and a plurality of wireless charging antennas disposed in the plurality of flexible areas and having a coil shape. The plurality of wireless charging antennas each may be electrically connected in parallel with the wireless charging circuit.

According to an example embodiment, a power supply device may comprise a ground portion and a protrusion formed as the ground portion protrudes. The protrusion may include a circuit board layer including a plurality of flexible areas and a plurality of wireless charging antennas disposed in the plurality of flexible areas and having a coil shape. The protrusion may include a guide area having a shape corresponding to a shape of a guide member included in an electronic device receiving power from the power supply device. The ground portion may be shielded through a shielding member.

### [ADVANTAGEOUS EFFECTS]

According to various example embodiments, it is possible to allow for an antenna arrangement for wireless charging with the optimal efficiency by efficiently using the internal space of the electronic device.

According to various example embodiments, it is possible to enhance/improve charging efficiency by arranging one or more wireless charging antennas even without a separate FPCB or PCB for wireless charging.

Effects of the disclosure are not limited to the foregoing, and other unmentioned effects would be apparent to one of ordinary skill in the art from the following description.

### [BRIEF DESCRIPTION OF THE DRAWINGS]

FIG. 1 illustrates a wireless charging system according to an example embodiment;
FIG. 2A illustrates an example of a wireless charging structure of an electronic device according to an example embodiment; FIG. 2B illustrates an example of a wireless charging structure of an electronic device according to an example embodiment;
FIG. 3 is a cross-sectional view illustrating a wireless charging structure according to an example embodiment;
FIG. 4 illustrates an example of a wireless charging structure according to an example embodiment;
FIG. 5 illustrates an example of a wireless charging structure according to an example embodiment;
FIG. 6 illustrates an electronic device and a power supply device according to an example embodiment;
FIG. 7A is a cross-sectional view illustrating a power supply device according to an example embodiment; FIG. 7B is a cross-sectional view illustrating a power supply device and an electronic device coupled to each other according to an example embodiment;
FIG. 8 is a block diagram illustrating an electronic device in a network environment according to various example embodiments; and
FIG. 9 is a block diagram illustrating a wireless communication module, a power management module, and an antenna module of an electronic device according to various example embodiments.

The same or similar reference denotations may be used to refer to the same or similar elements throughout the specification and the drawings.

### [DETAILED DESCRIPTION]

Hereinafter, embodiments of the present disclosure are described with reference to the accompanying drawings. However, it should be appreciated that the present disclosure is not limited to the embodiments, and all changes and/or equivalents or replacements thereto also belong to the scope of the present disclosure. In the following description, the same/similar reference numerals are used to denote substantially the same components, and no duplicate description is given.

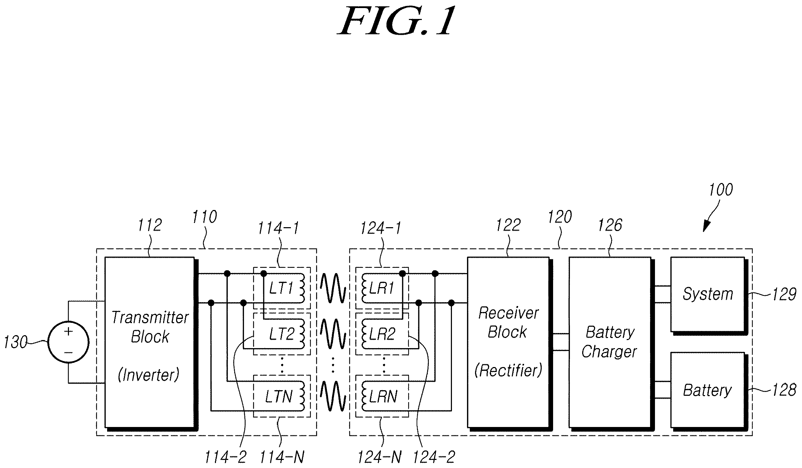

FIG. 1 illustrates a wireless charging system according to an embodiment.

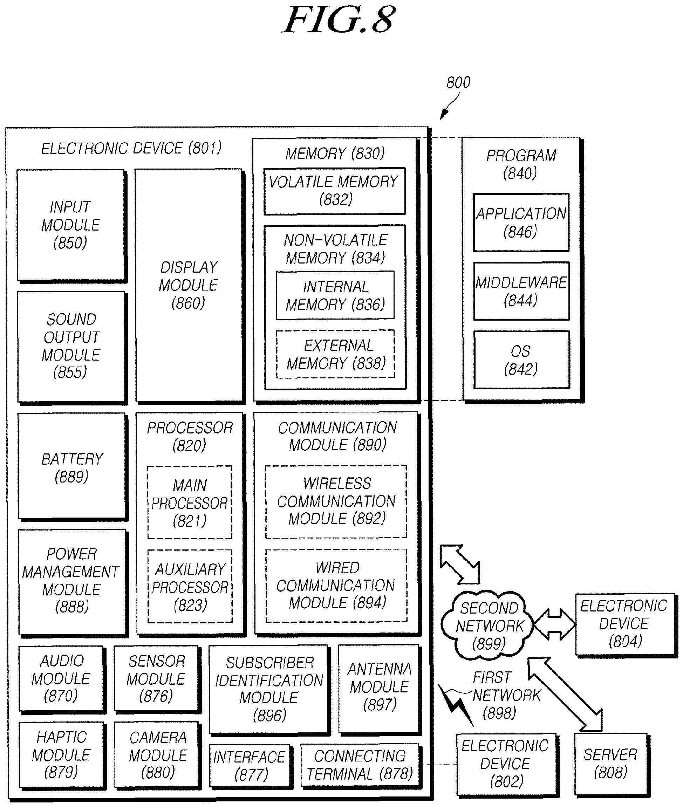

Referring to FIG. 1, a wireless charging system 100 according to an embodiment may include a power supply device 110, an electronic device 120, and a power source 130. The electronic device 120 may include the electronic device 801 described with reference to FIG. 8. The power supply device 110 according to an embodiment may be electrically connected to the power source 130 through a cable or the like. The power supply device 110 according to an embodiment may include a battery (not shown) and transmit at least a portion of the power supplied from the battery (not shown) to the electronic device 120. The power supply device 110 and the electronic device 120 according to an embodiment may be disposed adj acent to each other to receive power.

The power supply device 110 according to an embodiment may represent a device for supplying power to the electronic device 120 in the wireless charging system 100. The power supply device 110 according to an embodiment may include a power transmitter 112 and a plurality of transmission antennas 114-1, 114-2, ... , and 114-N.

In an embodiment, the power transmitter 112 may convert the alternating current (AC) signal received from the power source 130 into a direct current (DC) signal. The power transmitter 112 may convert the converted DC signal back into an AC signal and supply it to the plurality of transmission antennas 114-1, 114-2, ... , and 114-N.

In an embodiment, the plurality of transmission antennas 114-1, 114-2, ... , and 114-N each may be connected in parallel to the power transmitter 112. In an embodiment, the power supply device 110 may transfer an AC signal to the plurality of transmission antennas 114-1, 114-2, ... , and 114-N to generate an electromagnetic field for each of the plurality of transmission antennas 114-1, 114 -2, ..., and 114-N. In an embodiment, the power supply device 110 may transmit AC signals of the same frequency band to another electronic device through the plurality of transmission antennas 114-1, 114-2, ... , and 114-N.

In an embodiment, the plurality of transmission antennas 114-1, 114-2, ... , and 114-N, respectively, may correspond to a plurality of reception antennas 124-1, 124-2, ... , and 124-N. For example, the transmission antenna 114-1 may correspond to the reception antenna 124-1. The transmission antenna 114-2 may correspond to the reception antenna 124-2. The transmission antenna 114-N may correspond to the reception antenna 124-N.

In an embodiment, the plurality of reception antennas 124-1, 124-2, ... , and 124-N and the plurality of transmission antennas 114-1, 114-2, ... , and 114-N corresponding to each other may be disposed adjacent to each other.

The electronic device 120 according to an embodiment may represent a device receiving the power from the power supply device 110 in the wireless charging system 100. The electronic device 120 according to an embodiment may include a plurality of reception antennas 124-1, 124-2, ... , and 124-N for receiving power, a power receiver 122 processing the signals received from the plurality of reception antennas 124-1, 124-2, ... , and 124-N, a battery charger 126 charging a battery 128 based on the signals processed by the power receiver 122, the battery 128, and a system 129.

In an embodiment, the plurality of reception antennas 124-1, 124-2, ... , and 124-N may correspond in pair to the plurality of transmission antennas 114-1, 114-2, ... , and 114-N, respectively. For example, the reception antenna 124-1 may correspond in pair to the transmission antenna 114-1. The reception antenna 124-2 may correspond in pair to the transmission antenna 114-2. The reception antenna 124-N may correspond in pair to the transmission antenna 114-N.

In an embodiment, the plurality of reception antennas 124-1, 124-2, ... , and 124-N and the plurality of transmission antennas 114-1, 114-2, ... , and 114-N corresponding to each other may be disposed adjacent to each other. For example, they may be disposed to have a value equal to or less than a predetermined distance.

In an embodiment, the plurality of reception antennas 124-1, 124-2, ... , and 124-N and the plurality of transmission antennas 114-1, 114-2, ... , and 114-N may resonate with each other based on the AC signals. Resonance may be performed based on a fixed frequency or a variable frequency. "Based on" as used herein covers based at least on.

In an embodiment, although not shown in the drawings, the electronic device 120 may include matching circuits disposed between the power receiver 122 and the plurality of reception antennas 124-1, 124-2, ... , and 124-N. The plurality of reception antennas 124-1, 124-2, ... , and 124-N each may be connected in parallel to the power receiver 122, and the lines between the plurality of reception antennas 124-1, 124-2, ... , and 124-N and the power receiver 122 may have different lengths. Due to such differences, a delay or a difference in resistance may occur between the signals received from the respective reception antennas. The electronic device 120 may include a matching circuit configured by combining various components, such as a filter design, a matching material, a passive element cap, an inductor, and the like, and a plurality of reception antennas 124-1, 124-2, ... , and 124-N may be generated with the same characteristics through the matching circuits.

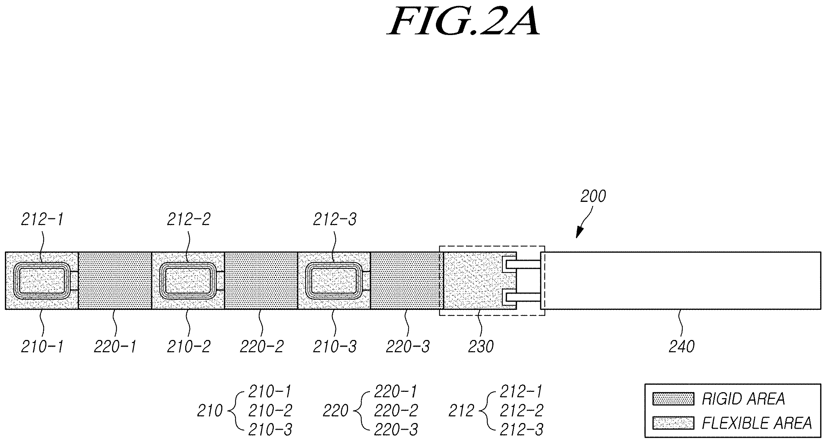

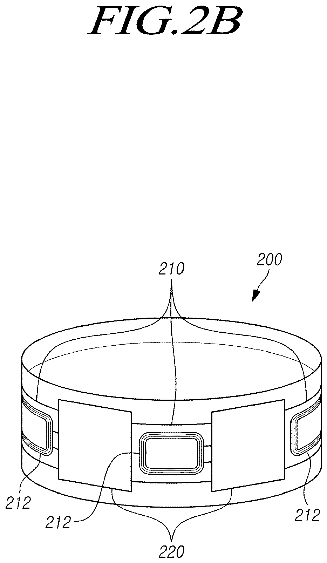

FIG. 2A illustrates an example of a wireless charging structure of an electronic device according to an embodiment. FIG. 2B illustrates an example of a wireless charging structure of an electronic device according to an embodiment. The wireless charging structure of the electronic device shown in FIGS. 2A and 2B may represent the wireless charging structure of the electronic device 120 of FIG. 1.

The wireless charging structure 200 according to an embodiment may be utilized not only in general portable terminals (e.g., smartphones), but also in wearable electronic devices having a relatively small component mounting space, such as smart watches, smart rings, and ear buds. The wireless charging structure 200 according to various example embodiments may include a flexible printed circuit board (FPCB) (hereinafter referred to as FPCB) and components disposed on two opposite surfaces of the flexible printed circuit board. The wireless charging structure 200 according to an embodiment may have a planar structure or a curved structure in which a flat structure is curved such that two opposite ends thereof are connected, depending on the shape in which it is disposed.

Referring to FIG. 2A, an electronic device 120 according to an embodiment may include a plurality of flexible areas 210, a plurality of wireless charging antennas 212, a plurality of rigid areas 220, a connection area 230, and a battery 240.

Referring to FIG. 2A, the wireless charging structure 200 according to an embodiment may include three rigid areas (a first rigid area 220-1, a second rigid area 220-2, and a third rigid area 220-3). The rigid areas (e.g., the first rigid area 220-1, the second rigid area 220-2, and the third rigid area 220-3) may indicate areas, where a rigid PCB (hereinafter, referred to as a PCB) not foldable or bendable is disposed, of an entire surface of the FPCB (e.g., the surface facing the inner layer if it has a curved structure).

In an embodiment, a plurality of PCBs may be disposed to be spaced apart from each other by a predetermined interval on the FPCB of the wireless charging structure 200. Accordingly, a plurality of rigid areas 220 may be formed in the wireless charging structure 200. Although FIG. 2A illustrates that the wireless charging structure 200 may include three rigid areas, this is merely an example and the wireless charging structure 200 may include more or fewer than three rigid areas.

In an embodiment, the first rigid area 220-1 may be of or include a rigid area formed first from an end (first end), in a direction, of the wireless charging structure 200. The second rigid area 220-2 may be of or include a rigid area formed second from the first end of the wireless charging structure 200. The third rigid area 220-3 may be of or include a rigid area formed third from the first end of the wireless charging structure 200.

In an embodiment, although not shown, a wireless charging circuit (e.g., the power receiver 122 and battery charger 126 of FIG. 1) may be disposed in any one area among the first rigid area 220-1, the second rigid area 220-2, and the third rigid area 220-3.

In an embodiment, although not shown in the drawings, matching circuits may be disposed in the first rigid area 220-1, the second rigid area 220-2, and the third rigid area 220-3, respectively. The matching circuit may represent a component for matching electrical characteristics in order for a plurality of charging antennas to operate identically.

Referring to FIG. 2A, the wireless charging structure 200 according to an embodiment may include three flexible areas (a first flexible area 210-1, a second flexible area 210-2, and a third flexible area 210-3). The flexible area 210 may be of or include an area divided from the rigid area in the entire area of the FPCB of the wireless charging structure 200, and a wireless charging antenna may be disposed in the flexible area 210. Due to the plurality of rigid areas formed in the FPCB, the wireless charging structure 200 may include the plurality of flexible areas. Although FIG. 2A illustrates that the wireless charging structure 200 may include three flexible areas, this is merely an example and the wireless charging structure 200 may include more or fewer than three flexible areas.

In an embodiment, the first flexible area 210-1 may be of or include a flexible area formed first from an end, in a direction, of the wireless charging structure 200. The second flexible area 210-2 may be of or include a flexible area formed second from the end of the wireless charging structure 200. The third flexible area 210-3 may be of or include a flexible area formed third from the end of the wireless charging structure 200.

In an embodiment, a plurality of wireless charging antennas 212 may be disposed in the plurality of flexible areas 210. The wireless charging antenna may have the form of a coil for wireless charging.

In an embodiment, the first wireless charging antenna 212-1 may be of or include a wireless charging coil disposed in the first flexible area 210-1. The second wireless charging antenna 212-2 may be of or include a wireless charging coil disposed in the second flexible area 210-2. The third wireless charging antenna 212-3 may be of or include a wireless charging coil disposed in the third flexible area 210-3.

In an embodiment, each of the plurality of wireless charging antennas 210 may be connected in parallel to the wireless charging circuit (not shown) in the rigid area.

In an embodiment, lines (not shown) for connecting each of the plurality of wireless charging antennas to the wireless charging circuit (not shown) may be formed over a plurality of FPCB layers.

In an embodiment, the plurality of wireless charging antennas may include a first line and a second line. The first line and the second line may be connected, directly or indirectly, to the wireless charging circuit (not shown) by the plurality of FPCB layers in the wireless charging structure 200.

In an embodiment, to connect the plurality of wireless charging antennas 210 and the wireless charging circuit (not shown) in parallel, the wireless charging structure 200 may include a plurality of vias.

In an embodiment, a matching circuit (not shown) may be disposed between each of the plurality of wireless charging antennas and the wireless charging circuit (not shown).

The connection area 230 according to an embodiment is an area that connects the battery 240 and the FPCB and may indicate a portion connected to the battery 240, other than the flexible area and the rigid area, of the entire area of the FPCB.

In an embodiment, a plurality of vias for connecting, in parallel, the lines for charging the battery, which are formed from the plurality of flexible areas 210 and the plurality of rigid areas 220, may be disposed in the connection area.

In an embodiment, the battery 240 may be a component for supplying power to the electronic device 120.

Referring to FIG. 2B, the wireless charging structure 200 according to an embodiment may have a curved structure formed by connecting a first end and a second end opposite to the first end. For example, although not shown in the drawings, the battery 240 and the first flexible area 210-1 may be connected, directly or indirectly. Further, for example, the wireless charging structure 200 may include another connection area (not shown) connected to the battery 240 toward the second end. The other connection area may be connected to the first flexible area 210-1.

The wireless charging structure having the curved structure may be utilized in electronic devices having a curved design, such as smart rings or smart watches. When a plurality of flexible sections are required by the nature of such devices, it is possible to provide the optimal wireless charging efficiency by using a plurality of wireless charging antennas without the need to place a separate PCB or FPCB for wireless charging. Since both the wireless charging antenna and the wireless charging circuit are connected in parallel, a conventional charging circuit including a single antenna except for the antenna unit may be used equally. It is also possible to mitigate deterioration of efficiency due to a small antenna space by using a plurality of wireless charging antennas using a plurality of flexible PCB spaces in a small electronic device whose size and efficiency would be limited if a single wireless charging antenna were used.

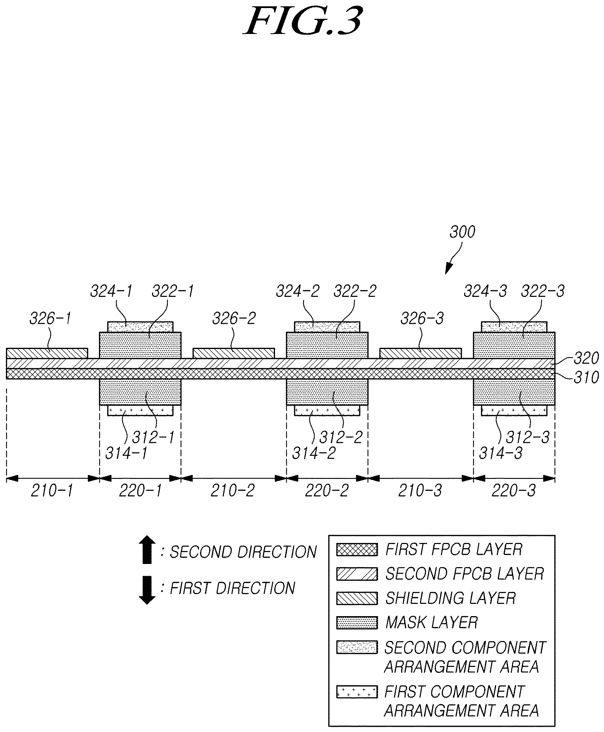

FIG. 3 is a cross-sectional view illustrating a wireless charging structure according to an embodiment.

The wireless charging structure 300 shown in FIG. 3 is one that omits some components from the wireless charging structure 200 shown in FIG. 2 and adds some components. The wireless charging structure 300 shown in FIG. 3 is an example, and other components than those shown in FIG. 3 may be added, and some of the components shown in FIG. 3 may be omitted.

Referring to FIG. 3, a wireless charging structure 300 according to an embodiment may include a first FPCB 310 layer, a second FPCB layer 320, a first mask layer 312, a second mask layer 322, a first component arrangement area 314, a second component arrangement area 324, and a shielding layer 326. The wireless charging structure 300 according to an embodiment may include a cover layer (not shown) formed at the periphery of the FPCB layer (e.g., the first FPCB layer or the second FPCB layer). The wireless charging structure 300 according to an embodiment may include a separate photo solder resist (PSR) layer in the cover layer formed in the portion where the rigid area is positioned. The wireless charging structure 300 according to an embodiment may have a structure in which only the pad is exposed to the FPCB layer (e.g., the first FPCB layer or the second FPCB layer).

The wireless charging structure 300 according to an embodiment may include flexible areas 210-1, 210-2, and 210-3 and rigid areas 220-1, 220-2, and 220-3. In an embodiment, the rigid areas 220-1, 220-2 and 220-3 may indicate areas where the first mask layers 312-1, 312-2 and 312-3 are disposed on the first FPCB layer 310. In an embodiment, the flexible areas 210-1, 210-2, and 210-3 may be areas separated by the rigid areas 220-1, 220-2 and 220-3, respectively, on the first FPCB layer 310.

In an embodiment, although not shown in the drawings, at least one other FPCB layer may be disposed between the first FPCB layer 310 and the second FPCB layer 320. In other words, the wireless charging structure 300 is described as including two FPCB layers, but this is merely an example, and the wireless charging structure according to an embodiment may include three or more FPCB layers.

In an embodiment, although not shown in the drawings, lines through which signals are transferred may be included in the first FPCB layer 310 and the second FPCB layer 320. The lines may be disposed to pass through the first FPCB layer 310 and the second FPCB layer 320. The lines may be disposed to pass through the first FPCB layer 310 and the second FPCB layer 320 and to cross each other. Although not shown in the drawings, signals may be transmitted and received between the components disposed in the component arrangement area (e.g., the first component arrangement area 314 or the second component arrangement area 324) through the lines and vias (not shown) passing through the first FPCB layer 310 and the second FPCB layer 320.

In an embodiment, although not shown in the drawings, the wireless charging structure 300 may form an annular structure bent in a first direction or a second direction. For example, the wireless charging structure 300 may form an annular structure bent in the first direction. In other words, the first direction may be a direction toward the inner side of the electronic device (e.g., a smart ring) having a curved surface. In this case, the second direction may be a direction toward the outer side. In the following description, the wireless charging structure 300 is described with an example in which the first direction is a direction toward the inner side, but this is merely an example. The following description of the wireless charging structure of the electronic device may likewise apply where the first direction is a direction toward the outer side, and the second direction is a direction toward the inner side.

In an embodiment, components (e.g., a wireless charging circuit and a matching circuit) and sensors (e.g., a proximity sensor) for wireless charging may be disposed in the first component arrangement area 314. According to an embodiment, a sensor for measuring the signal of the user's body may be disposed in the first component arrangement area 314. In an embodiment, the sensors disposed in the first component arrangement area 314 may be deactivated while the electronic device is mounted on the power supply device.

In an embodiment, although not shown in the drawings, the first mask layer 312-1, 312-2, and 312-3 may have a shielding area surrounding the first component arrangement area 314-1, 314-2, and 314-3.

In an embodiment, although not shown in the drawings, the wireless charging structure 300 may include a fill-cut area obtained by fill-cutting a portion of the first component arrangement area 314-1, 314-2, and 314-3. For example, the fill-cut area may be fill-cut and may thus lack a copper layer.

In an embodiment, although not shown in the drawings, wireless charging antennas for wireless charging may be disposed in the flexible areas 210-1, 210-2, and 210-3. In an embodiment, a fill-cut area obtained by fill-cutting a portion of the flexible areas 210-1, 210-2, and 210-3 may be included. In an embodiment, the wireless charging antenna may be disposed in the fill-cut area of the flexible area.

In an embodiment, components related to short-range wireless communication (e.g., Bluetooth (BL) or Bluetooth low-energy (BLE)), radio frequency (RF) components, and RF antennas may be disposed in the second component arrangement area 324-1, 324-2, and 324-3. Through this arrangement, it is possible to minimize or reduce interference between the component in the first direction where the wireless charging antenna is disposed and the wireless charging circuit. In an embodiment, sensors (e.g., a proximity sensor) may be disposed in the second component arrangement area 324. For example, a sensor for measuring the signal of the user's body may be disposed in the second component arrangement area 324.

In an embodiment, in the wireless charging structure 300, areas other than the second mask layer 322-1, 322-2, and 322-3 in the second FPCB layer 320 may be shielded by a shielding layer (e.g., or shielding tape or other shielding material).

In an embodiment, all areas other than the portion where the first component and the second component are disposed may be shielded.

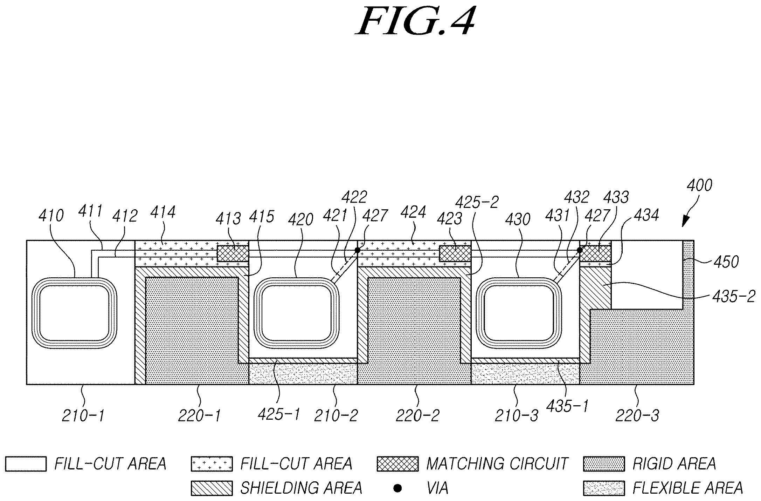

FIG. 4 illustrates an example of a wireless charging structure 400 according to an embodiment. The wireless charging structure shown in FIG. 4 may be a detailed representation of the wireless charging structure 200 of FIG. 2A. The wireless charging structure shown in FIG. 4 may be illustrated with the battery 240 and the connection area 230 omitted from the wireless charging structure 200.

According to an embodiment, the wireless charging structure 400 may include flexible areas (e.g., the first flexible area 210-1, the second flexible area 210-2, and the third flexible area 210-3), rigid areas (e.g., the first rigid area 220-1, the second rigid area 220-2, and the third rigid area 220-3), and a wireless charging circuit 450.

In an embodiment, the first flexible area 210-1 may be of or include a flexible area formed first from the first end of the wireless charging structure 400. The second flexible area 210-2 may be of or include a flexible area formed second from the first end of the wireless charging structure 400. The third flexible area 210-3 may be of or include a flexible area formed third from the first end of the wireless charging structure 400. In an embodiment, the first rigid area 220-1 may be of or include a rigid area formed first from the first end of the wireless charging structure 400. The second rigid area 220-2 may be of or include a rigid area formed second from the first end of the wireless charging structure 400. The third rigid area 220-3 may be of or include a rigid area formed third from the first end of the wireless charging structure 400. For what may be commonly applied in the following description, the first flexible area 210-1, the second flexible area 210-2, and the third flexible area 210-3 may collectively be referred to as the flexible area 210, and the first rigid area 220-1, the second rigid area 220-2, and the third rigid area 220-3 may collectively be referred to as the rigid area 220.

In an embodiment, the wireless charging antennas (e.g., the first wireless charging antenna 410, the second wireless charging antenna 420, and the third wireless charging antenna 430) may be disposed in each flexible area 210. For example, the first wireless charging antenna 410 may be disposed in the first flexible area 210-1, the second wireless charging antenna 420 may be disposed in the second flexible area 210-2, and the third wireless charging antenna 430 may be disposed in the third flexible area 210-3. For what may be commonly applied in the following description, the first wireless charging antenna 410, the second wireless charging antenna 420, and the third wireless charging antenna 430 may collectively be referred to as the wireless charging antenna.

In an embodiment, the first wireless charging antenna 410, the second wireless charging antenna 420, and the third wireless charging antenna 430 may all be coil-shaped antennas. Although the wireless charging antenna is separately described as the first wireless charging antenna 410, the second wireless charging antenna 420 or the third wireless charging antenna 430 depending on the area where the wireless charging antenna is disposed, the first wireless charging antenna 410, the second wireless charging antenna 420, and the third wireless charging antenna 430 may all be the same antenna.

In an embodiment, the wireless charging antenna 410, 420, or 430 may be disposed in the fill-cut area which is a portion obtained by fill-cutting an upper end portion of the flexible area (e.g., the first flexible area 210-1, the second flexible area 210-2, or the third flexible area 210-3).

In an embodiment, a component for performing the wireless charging function or at least one sensor (e.g., a motion sensor, heartrate sensor, stress sensor, ultraviolet sensor, or oxygen saturation sensor) may be disposed on the PCB of the rigid area (e.g., the first rigid area 220-1, the second rigid area 220-2, or the third rigid area 220-3).

In an embodiment, the rigid areas (e.g., the first rigid area 220-1, the second rigid area 220-2, and the third rigid area 220-3), respectively, may include fill-cut areas 414, 424, and 434, formed by fill-cutting their upper end portions.

In an embodiment, the wireless charging circuit 450 may be disposed in the third rigid area 220-3. For example, the wireless charging circuit 450 may be disposed in the third rigid area 220-3. The wireless charging circuit 450 may include the power receiver 122 and the power charger 126 of FIG. 1.

In an embodiment, the shielding areas 415, 425-1, 425-2, and 435 (e.g., see 435-1 and/or 435-2) may be formed around the components disposed in the rigid area 220 or the flexible area 210. The shielding area may be formed between a component except for those for wireless charging and the area through which the charging line passes. The shielding area may be of or include a layer formed on an outer layer of the FPCB layer to shield noise. The shielding area may achieve shielding by ground-filling the corresponding area of each layer, thereby minimizing or reducing interference by the wireless charging frequency component. The shielding areas 415, 425-1, 425-2 and 435 (e.g., see 435-1 and/or 435-2) may be formed through a shielding tape. In an embodiment, the shielding area may also be formed in an area where the wireless charging antenna is disposed.

In an embodiment, the shielding area 415 may be formed in the first rigid area 220-1 along the boundary between the first rigid area 220-1 and the first flexible area 210-1, the boundary of the fill-cut area 414 of the first rigid area 220-1, and the boundary of the second flexible area 210-2.

In an embodiment, the shielding area 425-1 may be formed in the second flexible area 210-2, along the boundary between the second flexible area 210-2 and the fill-cut area of the second flexible area 210-2.

In an embodiment, the shielding area 425-2 may be formed in the second rigid area 220-2, along the boundary between the second flexible area 210-2 and the second rigid area 220-2, the boundary between the fill-cut area 424 and the second rigid area 220-2, and the boundary between the third flexible area 210-3 and the second rigid area 220-2.

In an embodiment, the shielding area 435-1 may be formed in the third flexible area 210-3, along the boundary between the third flexible area 210-3 and the fill-cut area of the third flexible area 210-3.

In an embodiment, the shielding area 435-2 may be formed in the boundary area between the third flexible area 210-3 and the third rigid area 220-3, in the third rigid area 220-3. In an embodiment, the wireless charging circuit may be grounded with a ground layer.

In an embodiment, the wireless charging structure 400 may include matching circuits 413, 423, and 433. The matching circuits 413, 423, and 433 may be disposed in the fill-cut areas 414, 424, and 434, respectively, of the rigid area 220. The charging lines connecting the wireless charging antennas 410, 420, and 430 and the wireless charging circuit may have different lengths. Due to the difference in the length or path of the charging line, a delay or difference in resistance may occur between the signals received by the wireless charging circuit 450 from the wireless charging antennas. The matching circuits 413, 423, and 433 are components for minimizing/reducing such delay or difference in resistance and may be of or include components configured by combining a filter design, matching material, passive element cap, inductor, or other components. Through the matching circuits 413, 423, and 433, the wireless charging antennas 410, 420, and 430 may be generated with the same characteristics.

In an embodiment, it is possible to minimize or reduce interference with the components disposed on the PCB by the components for wireless charging through the shielding area formed through, e.g., a shielding tape around the PCB of the first charging line (e.g., the first line 411 or second line 412) and the wireless charging antenna 410.

In an embodiment, the wireless charging antennas 410, 420, and 430 each may be connected, directly or indirectly, to the wireless charging circuit 450 through the wireless charging line (e.g., the first line or the second line). The wireless charging antennas 410, 420, and 430 may be electrically connected in parallel to the wireless charging circuit 450.

In an embodiment, the charging line may include the first line and the second line. For example, a first charging line connecting the wireless charging antenna 410 and the wireless charging circuit 450 may include a first line 411 and a second line 412. The second charging line connecting the second wireless charging antenna 420 and the wireless charging circuit 450 may include a first line 421 and a second line 422. The third charging line connecting the third wireless charging antenna 430 and the wireless charging circuit 450 may include a first line 431 and a second line 433.

In an embodiment, although not shown in the drawings, the wireless charging lines (e.g., the first lines 411, 421, and 431 and the second lines 412, 422, and 432) may be formed so that two lines pass through two or more layers (e.g., the first FPCB layer 310 and the second FPCB layer 320) through vias (e.g., the via(s) 427) and cross each other at 90 degrees so as to minimize or reduce interference. Although only two vias 427 are illustrated in FIG. 4, this is merely an example, and the wireless charging structure according to an embodiment may include more or fewer than two vias.

In an embodiment, the first line 411 and the second line 412 connecting the first wireless charging antenna 410 and the wireless charging circuit 450 may be disposed only on one layer (e.g., the first FPCB layer 310). This is why it is the first wireless charging antenna to be disposed and thus be included in only one layer.

In an embodiment, the first lines 411, 421, and 431 and the second lines 412, 422, and 433 of the wireless charging antennas 410, 420, and 430, respectively, may be connected through the matching circuits 413, 423, and 433 to the wireless charging circuit 450.

In an embodiment, although not shown in the drawings, the first lines 411, 421, and 431 and the second lines 412, 422, and 432 may all be disposed in the fill-cut area which is formed by fill-cutting the upper layer thereof.

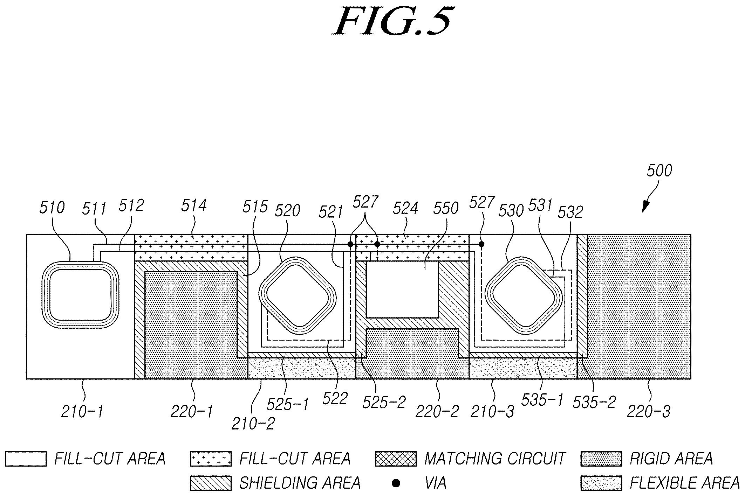

FIG. 5 illustrates an example of a wireless charging structure according to an embodiment. The wireless charging structure shown in FIG. 5 may be a detailed representation of the wireless charging structure 200 of FIG. 2A. The wireless charging structure shown in FIG. 5 may be a structure in which the battery 240 and the connection area 230 has been omitted from the wireless charging structure 200. The wireless charging structure shown in FIG. 5 may be an example in which the wireless charging structure 400 of FIG. 4 omits some components and adds other components. In the description of the wireless charging structure 500 of FIG. 5, a description of a portion overlapping or corresponding to FIG. 4 may be omitted.

According to an embodiment, the wireless charging structure 500 may include flexible areas (e.g., the first flexible area 210-1, the second flexible area 210-2, and the third flexible area 210-3), rigid areas (e.g., the first rigid area 220-1, the second rigid area 220-2, and the third rigid area 220-3), and a wireless charging circuit 550.

In an embodiment, the first flexible area 210-1 may be of or include a flexible area formed first from the first end of the wireless charging structure 500. The second flexible area 210-2 may be of or include a flexible area formed second from the first end of the wireless charging structure 500. The third flexible area 210-3 may be of or include a flexible area formed third from the first end of the wireless charging structure 500. In an embodiment, the first rigid area 220-1 may be of or include a rigid area formed first from the first end of the wireless charging structure 500. The second rigid area 220-2 may be of or include a rigid area formed second from the first end of the wireless charging structure 500. The third rigid area 220-3 may be of or include a rigid area formed third from the first end of the wireless charging structure 500. For what may be commonly applied in the following description, the first flexible area 210-1, the second flexible area 210-2, and the third flexible area 210-3 may collectively be referred to as the flexible area 210, and the first rigid area 220-1, the second rigid area 220-2, and the third rigid area 220-3 may collectively be referred to as the rigid area 220.

In an embodiment, the wireless charging antennas (e.g., the first wireless charging antenna 510, the second wireless charging antenna 520, and the third wireless charging antenna 530) may be disposed in each flexible area 210. For example, the first wireless charging antenna 510 may be disposed in the first flexible area 210-1, the second wireless charging antenna 520 may be disposed in the second flexible area 210-2, and the third wireless charging antenna 530 may be disposed in the third flexible area 210-3. For what may be commonly applied in the following description, the first wireless charging antenna 510, the second wireless charging antenna 520, and the third wireless charging antenna 530 may collectively be referred to as the wireless charging antenna.

In an embodiment, the first wireless charging antenna 510, the second wireless charging antenna 520, and the third wireless charging antenna 530 may all have a coil shape. In the following description, although the wireless charging antenna is separately described as the first wireless charging antenna 510, the second wireless charging antenna 520 or the third wireless charging antenna 530 depending on the area where the wireless charging antenna is disposed, the first wireless charging antenna 510, the second wireless charging antenna 520, and the third wireless charging antenna 530 may all be the same antenna.

In an embodiment, the wireless charging antenna 510, 520, or 530 may be disposed in the fill-cut area which is a portion obtained by fill-cutting an upper end portion of the flexible area (e.g., the first flexible area 210-1, the second flexible area 210-2, or the third flexible area 210-3).

In an embodiment, a component for performing the wireless charging function or at least one sensor (e.g., a motion sensor, heartrate sensor, stress sensor, ultraviolet sensor, or oxygen saturation sensor) may be disposed in the rigid area (e.g., the first rigid area 220-1, the second rigid area 220-2, or the third rigid area 220-3).

In an embodiment, the rigid areas (e.g., the first rigid area 220-1, the second rigid area 220-2, and the third rigid area 220-3), respectively, may include fill-cut areas 514, 524, and 534, formed by fill-cutting their upper end portions.

In an embodiment, the shielding areas 515, 525-1, 525-2, and 535 may be formed around the components disposed in the rigid area 220 or the flexible area 210. The shielding area may be of or include a layer formed on an outer layer of the FPCB layer to shield noise. The shielding area may be formed between a component except for those for wireless charging and the area through which the charging line passes. The shielding area may achieve shielding by ground-filling the corresponding area of each layer, thereby minimizing or reducing interference by the wireless charging frequency component. The shielding areas 515, 525-1, 525-2 and 535 may be formed through a shielding layer (e.g., a shielding tape or other shielding material). In an embodiment, the shielding area may also be formed in an area where the wireless charging antenna is disposed.

In an embodiment, the shielding area 515 may be formed in the first rigid area 220-1 along the boundary between the first rigid area 220-1 and the first flexible area 210-1, the boundary of the fill-cut area 514 of the first rigid area 220-1, and the boundary of the second flexible area 210-2.

In an embodiment, the shielding area 525-1 may be formed in the second flexible area 210-2, along the boundary between the second flexible area 210-2 and the fill-cut area of the second flexible area 210-2.

In an embodiment, the shielding area 525-2 may be formed in the second rigid area 220-2, along the boundary between the second flexible area 210-2 and the second rigid area 220-2, the boundary between the fill-cut area 524 and the second rigid area 220-2, and the boundary between the third flexible area 210-3 and the second rigid area 220-2.

In an embodiment, the shielding area 535-1 may be formed in the third flexible area 210-3, along the boundary between the third flexible area 210-3 and the fill-cut area of the third flexible area 210-3.

In an embodiment, the shielding area 535-2 may be formed at least partially in the second rigid area 220-2, except for the area where the wireless charging circuit 540 is positioned and the boundary between the third flexible area 210-3 and the third rigid area 220-3.

In an embodiment, it is possible to minimize or reduce interference with the components disposed in the rigid area by the components for wireless charging through, e.g., a shielding tape disposed around the charging line (e.g., the first line 511 and the second line 512) and the wireless charging antenna 510.

In an embodiment, the wireless charging antennas 510, 520, and 530 each may be connected to the wireless charging circuit 550 through the wireless charging line (e.g., the first line or the second line). The wireless charging antennas 510, 520, and 530 may be electrically connected in parallel to the wireless charging circuit 550.

In an embodiment, the charging line may include the first line and the second line. For example, the charging line connecting the wireless charging antenna 510 and the wireless charging circuit 550 may include a first line 511 and a second line 512. The charging line connecting the second wireless charging antenna 520 and the wireless charging circuit 550 may include a first line 521 and a second line 522. The charging line connecting the third wireless charging antenna 530 and the wireless charging circuit 550 may include a first line 531 and a second line 532.

In an embodiment, although not shown in the drawings, the wireless charging lines (e.g., the first lines 511, 521, and 531 and the second lines 512, 522, and 532) may be formed so that two lines pass through two or more layers (e.g., the first FPCB 310 and the second FPCB 320) through vias (e.g., the vias 527) and cross each other at 90 degrees so as to minimize or reduce interference. Although only three vias 527 are illustrated in FIG. 5, this is merely an example, and the wireless charging structure according to an embodiment may include more or fewer than two vias.

In an embodiment, the first line 511 and the second line 512 connecting the first wireless charging antenna 510 and the wireless charging circuit 550 may be disposed on one layer (e.g., the first FPCB layer 310). This is why it is the first wireless charging antenna to be disposed and thus be included in only one layer.

In an embodiment, although not shown in the drawings, the first lines 511, 521, and 531 and the second lines 512, 522, and 532 may all be disposed in the fill-cut area which is formed by fill-cutting.

In an embodiment, the wireless charging structure 500 may not include a matching circuit (e.g., the matching circuits 513, 523, and 533), unlike the wireless charging structure 400.

In an embodiment, unlike the wireless charging structure 400 shown in FIG. 4, the wireless charging circuit 550 may be disposed in the second rigid area 220-2. As the wireless charging circuit 550 is positioned in the center of the wireless charging structure 500, the difference between the lengths of the charging line between the wireless charging circuit 550 and the wireless charging antennas 510, 520, and 530 may be reduced as compared with that shown in FIG. 4, so that the differences in characteristics due to the difference in charging line length may be mitigated.

In an embodiment, the second wireless charging antenna 520 may be disposed to have a predetermined slope from the boundary line with the first rigid area 220-1. In an embodiment, the third wireless charging antenna 530 may be disposed to have a predetermined slope from the boundary line with the second rigid area 220-2. Accordingly, cross talk between wireless charging lines may be reduced.

In an embodiment, the first charging line (first line 511 and the second line 512), the second charging line (the first line 521 and the second line 522), and the third charging line (the first line 531 and the second line 532) may be disposed so that the lengths of the lines between the first wireless charging antenna 510, the second wireless charging antenna 520, and the third wireless charging antenna 530 and the wireless charging circuit 550 are the same. For example, to make the lengths of the charging lines the same, the second wireless charging antenna 520 and the third wireless charging antenna 530 may be disposed to have a predetermined slope.

The wireless charging structure 400 and the wireless charging structure 500 described in connection with FIGS. 4 and 5 are merely examples, and the wireless charging structure according to an embodiment may be configured by combining the respective parts of the wireless charging structure 400 and the wireless charging structure 500. For example, the wireless charging structure (not shown) may include a matching circuit in only some of the rigid areas included in the wireless charging structure (not shown). Further, as an example, in the wireless charging structure (not shown), the wireless charging antenna disposed in the second flexible area may be disposed not to have a predetermined slope while only the first wireless charging antenna and the third wireless charging antenna are disposed to have a predetermined slope. Further, for example, the wireless charging structure (not shown) may include more than two vias.

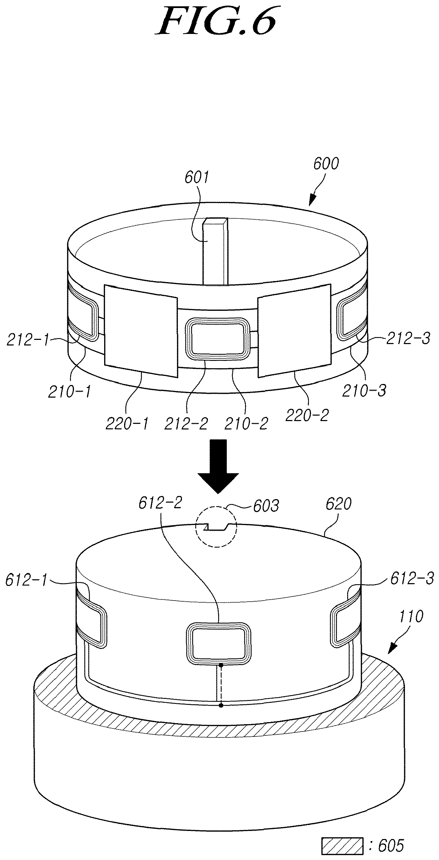

FIG. 6 illustrates an electronic device and a power supply device according to an embodiment. The electronic device 600 shown in FIG. 6 may be an electronic device corresponding to the electronic device 120 of FIG. 1. The electronic device shown in FIG. 6 may include the wireless charging structure 200 of FIGS. 2A and 2B and the wireless charging structure 300 of FIG. 3. The electronic device shown in FIG. 6 may include a wireless charging structure corresponding to the wireless charging structure 400 of FIG. 4 or the wireless charging structure 500 of FIG. 5.

Referring to FIG. 6, the electronic device 600 may receive power from the power supply device 110. The electronic device 600 may be disposed to be aligned with the power supply device 110 to receive power from the power supply device 110.

The power supply device 110 according to an embodiment may include a first wireless charging antenna 612-1, a second wireless charging antenna 612-2, and a third wireless charging antenna 612-3. The first wireless charging antenna 612-1, the second wireless charging antenna 612-2, and the third wireless charging antenna 612-3 may all be of or include wireless charging coils for power transmission.

In an embodiment, the electronic device 600 may be mounted on the power supply device 110 so that the first wireless charging antenna 212-1 is aligned with the first wireless charging antenna 612-1, the second wireless charging antenna 212-2 is aligned with the second wireless charging antenna 612-2, and the third wireless charging antenna 212-3 is aligned with the third wireless charging antenna 612-3. In other words, the corresponding wireless charging antennas (for transmission and/or reception) may be aligned with each other and may generate the same AC signals, thereby resonating.

The electronic device 600 according to an embodiment may include a guide member 601. The guide member 601 according to an embodiment may be of or include a protrusion protruding toward an inner side of the electronic device 600 having an annular structure.

The power supply device 100 according to an embodiment may include a protrusion 620 for coupling with the electronic device 600. The protrusion 620 may be formed in an annular structure corresponding to the electronic device 600 having an annular structure.

In an embodiment, the height of the protrusion 620 may correspond to the height of the electronic device 600.

The power supply device 110 according to an embodiment may include a guide area 603 into which the guide member 601 of the electronic device 600 is inserted. The guide area 603 may be of or include an area configured in the form of a recess to correspond to the protruding shape of the guide member 601 so that the guide member 601 of the electronic device 600 may be coupled thereto.

In an embodiment, the guide area 603 may be formed in a position where, when the electronic device 600 is mounted on the power supply device 110, the first wireless charging antenna 212-1 is aligned with the first wireless charging antenna 612-1, the second wireless charging antenna 212-2 is aligned with the second wireless charging antenna 612-2, and the third wireless charging antenna 212-3 is aligned with the third wireless charging antenna 612-3.

The power supply device 110 according to an embodiment may include a bottom area 605. The bottom area 605 may be of or include a component for stopping the electronic device 200 from further moving downward when the electronic device 200 is coupled to the power supply device 110, directly or indirectly.

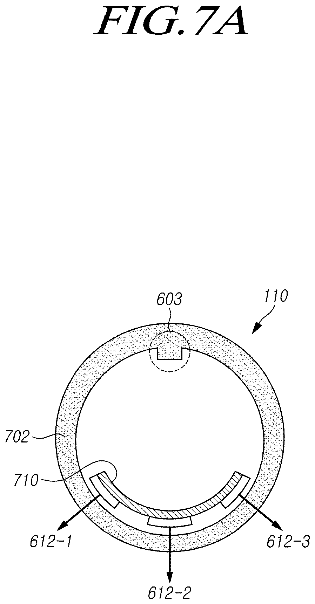

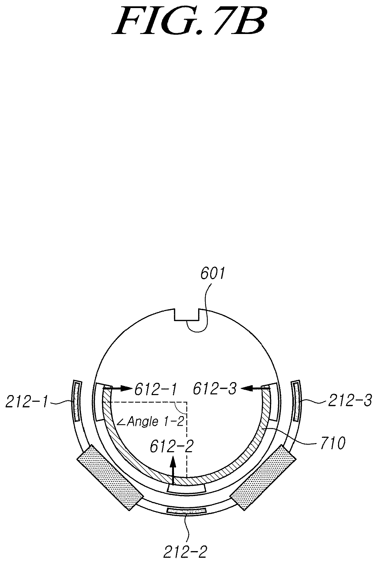

FIG. 7A is a cross-sectional view illustrating a power supply device according to an embodiment. FIG. 7B is a cross-sectional view illustrating a power supply device and an electronic device coupled to each other according to an embodiment.

A power supply device 110 according to an embodiment may include an FPCB 710, wireless charging antennas 612-1, 612-2, and 612-3, and a bottom area 702. In an embodiment, the wireless charging antennas 612-1, 612-2, and 612-3 may be disposed on the FPCB 710 formed in a curved structure. Although not shown in the drawings, the power supply device 110 may include a wireless charging structure similar to the wireless charging structure shown in FIGS. 3 to 5 for wireless charging.

Components (e.g., FPCB 710) on the inner side of the wireless charging antennas 612-1, 612-2, and 612-3 of the power supply device 110 according to an embodiment may be configured with a shielding layer (e.g., shielding tape) except for the area where the wireless charging antennas 612-1, 612-2, and 612-3 are disposed and the area where other components are disposed.

The power supply device 110 according to an embodiment may resonate (oscillate) the wireless charging antennas 612-1, 612-2, and 612-3, transmitting power to the electronic device (e.g., the electronic device 120 or the electronic device 600).

In an embodiment, the wireless charging antennas 612-1, 612-2, and 612-3, respectively, may be paired with the wireless charging antennas included in the electronic device.

In an embodiment, the power supply device 110 may include a guide area 603 to which the guide member (e.g., the guide member 601) may be coupled when the electronic device is seated on the power supply device 702 to receive power. The shape of the guide area 603 may correspond to the shape of the guide member 601.

In an embodiment, the power supply device 110 may include the bottom area 702 which is an area for fixing the electronic device not to move down further from its appropriate height when the electronic device is mounted on the power supply device 110. The bottom area 702 may be the area corresponding to the bottom area 605 of FIG. 6.

In an embodiment, the bottom area 702 may be constructed through a shielding layer (e.g., or shielding tape or other shielding material).

Referring to FIG. 7B, the electronic device (e.g., the electronic device 120 or 600) may be coupled to the power supply device 110 to wirelessly receive power from the power supply device 110. As the electronic device is coupled to the power supply device, the wireless charging antennas constituting the wireless charging structure of the electronic device may be respectively paired with the wireless charging antennas of the power supply device to receive power therefrom.

In an embodiment, the first wireless charging antenna 212-1 of the electronic device may correspond to the first wireless charging antenna 612-1 of the power supply device 110. The second wireless charging antenna 212-2 of the electronic device may correspond to the second wireless charging antenna 612-2 of the power supply device 110. The third wireless charging antenna 212-3 of the electronic device may correspond to the third wireless charging antenna 612-3 of the power supply device 110.

In an embodiment, the wireless charging antennas may be disposed on the FPCB 710 of the power supply device 110 so that the angle between the wireless charging antennas of the power supply device 110 may be a predetermined angle or more. For example, the angle of the first wireless charging antenna 612-1 and the second wireless charging antenna 612-2 (Angle of FIG. 7A) may be disposed in the power supply to be 45 degrees or more.

FIG. 8 is a block diagram illustrating an electronic device 801 in a network environment 800 according to various embodiments. Referring to FIG. 8, the electronic device 801 in the network environment 800 may communicate with at least one of an electronic device 802 via a first network 898 (e.g., a short-range wireless communication network), or an electronic device 804 or a server 808 via a second network 899 (e.g., a long-range wireless communication network). According to an embodiment, the electronic device 801 may communicate with the electronic device 804 via the server 808. According to an embodiment, the electronic device 801 may include a processor 820, memory 830, an input module 850, a sound output module 855, a display module 860, an audio module 870, a sensor module 876, an interface 877, a connecting terminal 878, a haptic module 879, a camera module 880, a power management module 888, a battery 889, a communication module 890, a subscriber identification module (SIM) 896, or an antenna module 897. In some embodiments, at least one (e.g., the connecting terminal 878) of the components may be omitted from the electronic device 801, or one or more other components may be added in the electronic device 101. According to an embodiment, some (e.g., the sensor module 876, the camera module 880, or the antenna module 897) of the components may be integrated into a single component (e.g., the display module 860).

The processor 820 may execute, for example, software (e.g., a program 840) to control at least one other component (e.g., a hardware or software component) of the electronic device 801 coupled with the processor 820, and may perform various data processing or computation. According to an embodiment, as at least part of the data processing or computation, the processor 820 may store a command or data received from another component (e.g., the sensor module 876 or the communication module 890) in volatile memory 832, process the command or the data stored in the volatile memory 832, and store resulting data in non-volatile memory 834. According to an embodiment, the processor 820 may include a main processor 821 (e.g., a central processing unit (CPU) or an application processor (AP)), or an auxiliary processor 823 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 801 includes the main processor 821 and the auxiliary processor 823, the auxiliary processor 823 may be configured to use lower power than the main processor 821 or to be specified for a designated function. The auxiliary processor 823 may be implemented as separate from, or as part of the main processor 821.

The auxiliary processor 823 may control at least some of functions or states related to at least one component (e.g., the display module 860, the sensor module 876, or the communication module 890) among the components of the electronic device 801, instead of the main processor 821 while the main processor 821 is in an inactive (e.g., sleep) state, or together with the main processor 821 while the main processor 821 is in an active state (e.g., executing an application). According to an embodiment, the auxiliary processor 823 (e.g., an image signal processor or a communication processor) may be implemented as part of another component (e.g., the camera module 880 or the communication module 890) functionally related to the auxiliary processor 123. According to an embodiment, the auxiliary processor 823 (e.g., the neural processing unit) may include a hardware structure specified for artificial intelligence model processing. The artificial intelligence model may be generated via machine learning. Such learning may be performed, e.g., by the electronic device 801 where the artificial intelligence is performed or via a separate server (e.g., the server 808). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 830 may store various data used by at least one component (e.g., the processor 820 or the sensor module 876) of the electronic device 801. The various data may include, for example, software (e.g., the program 840) and input data or output data for a command related thereto. The memory 830 may include the volatile memory 832 or the non-volatile memory 834.

The program 840 may be stored in the memory 830 as software, and may include, for example, an operating system (OS) 842, middleware 844, or an application 846.

The input module 850 may receive a command or data to be used by other component (e.g., the processor 820) of the electronic device 801, from the outside (e.g., a user) of the electronic device 801. The input module 850 may include, for example, a microphone, a mouse, a keyboard, keys (e.g., buttons), or a digital pen (e.g., a stylus pen).

The sound output module 855 may output sound signals to the outside of the electronic device 801. The sound output module 855 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 860 may visually provide information to the outside (e.g., a user) of the electronic device 801. The display 860 may include, for example, a display, a hologram device, or a projector and control circuitry to control a corresponding one of the display, hologram device, and projector. According to an embodiment, the display 860 may include a touch sensor configured to detect a touch, or a pressure sensor configured to measure the intensity of a force generated by the touch.

The audio module 870 may convert a sound into an electrical signal and vice versa. According to an embodiment, the audio module 870 may obtain the sound via the input module 850, or output the sound via the sound output module 855 or a headphone of an external electronic device (e.g., an electronic device 802) directly (e.g., wiredly) or wirelessly coupled with the electronic device 801.

The sensor module 876 may detect an operational state (e.g., power or temperature) of the electronic device 801 or an environmental state (e.g., a state of a user) external to the electronic device 101, and then generate an electrical signal or data value corresponding to the detected state. According to an embodiment, the sensor module 876 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 877 may support one or more specified protocols to be used for the electronic device 801 to be coupled with the external electronic device (e.g., the electronic device 802) directly (e.g., wiredly) or wirelessly. According to an embodiment, the interface 877 may include, for example, a high definition multimedia interface (HDMI), a universal serial bus (USB) interface, a secure digital (SD) card interface, or an audio interface.

A connecting terminal 878 may include a connector via which the electronic device 801 may be physically connected with the external electronic device (e.g., the electronic device 802). According to an embodiment, the connecting terminal 878 may include, for example, a HDMI connector, a USB connector, a SD card connector, or an audio connector (e.g., a headphone connector).

The haptic module 879 may convert an electrical signal into a mechanical stimulus (e.g., a vibration or motion) or electrical stimulus which may be recognized by a user via his tactile sensation or kinesthetic sensation. According to an embodiment, the haptic module 879 may include, for example, a motor, a piezoelectric element, or an electric stimulator.

The camera module 880 may capture a still image or moving images. According to an embodiment, the camera module 880 may include one or more lenses, image sensors, image signal processors, or flashes.

The power management module 888 may manage power supplied to the electronic device 801. According to an embodiment, the power management module 888 may be implemented as at least part of, for example, a power management integrated circuit (PMIC).

The battery 889 may supply power to at least one component of the electronic device 801. According to an embodiment, the battery 889 may include, for example, a primary cell which is not rechargeable, a secondary cell which is rechargeable, or a fuel cell.

The communication module 890 may support establishing a direct (e.g., wired) communication channel or a wireless communication channel between the electronic device 801 and the external electronic device (e.g., the electronic device 802, the electronic device 804, or the server 808) and performing communication via the established communication channel. The communication module 890 may include one or more communication processors that are operable independently from the processor 820 (e.g., the application processor (AP)) and supports a direct (e.g., wired) communication or a wireless communication. According to an embodiment, the communication module 890 may include a wireless communication module 892 (e.g., a cellular communication module, a short-range wireless communication module, or a global navigation satellite system (GNSS) communication module) or a wired communication module 894 (e.g., a local area network (LAN) communication module or a power line communication (PLC) module). A corresponding one of these communication modules may communicate with the external electronic device 804 via a first network 898 (e.g., a short-range communication network, such as Bluetooth^{™}, wireless-fidelity (Wi-Fi) direct, or infrared data association (IrDA)) or a second network 899 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 892 may identify or authenticate the electronic device 801 in a communication network, such as the first network 898 or the second network 899, using subscriber information (e.g., international mobile subscriber identity (IMSI)) stored in the subscriber identification module 896.

The wireless communication module 892 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 892 may support a high-frequency band (e.g., the mmWave band) to achieve, e.g., a high data transmission rate. The wireless communication module 892 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 892 may support various requirements specified in the electronic device 801, an external electronic device (e.g., the electronic device 804), or a network system (e.g., the second network 899). According to an embodiment, the wireless communication module 892 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 897 may transmit or receive a signal or power to or from the outside (e.g., the external electronic device). According to an embodiment, the antenna module 897 may include one antenna including a radiator formed of a conductor or conductive pattern formed on a substrate (e.g., a printed circuit board (PCB)). According to an embodiment, the antenna module 897 may include a plurality of antennas (e.g., an antenna array). In this case, at least one antenna appropriate for a communication scheme used in a communication network, such as the first network 898 or the second network 899, may be selected from the plurality of antennas by, e.g., the communication module 890. The signal or the power may then be transmitted or received between the communication module 890 and the external electronic device via the selected at least one antenna. According to an embodiment, other parts (e.g., radio frequency integrated circuit (RFIC)) than the radiator may be further formed as part of the antenna module 897. According to various embodiments, the antenna module 897 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 801 and the external electronic device 804 via the server 808 coupled with the second network 899. The external electronic devices 802 or 804 each may be a device of the same or a different type from the electronic device 801. According to an embodiment, all or some of operations to be executed at the electronic device 801 may be executed at one or more of the external electronic devices 802, 804, or 808. For example, if the electronic device 801 should perform a function or a service automatically, or in response to a request from a user or another device, the electronic device 801, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 801. The electronic device 801 may provide the outcome, with or without further processing of the outcome, as at least part of a reply to the request. To that end, a cloud computing, distributed computing, mobile edge computing (MEC), or client-server computing technology may be used, for example. The electronic device 801 may provide ultra low-latency services using, e.g., distributed computing or mobile edge computing. In another embodiment, the external electronic device 804 may include an Internet-of-things (IoT) device. The server 808 may be an intelligent server using machine learning and/or a neural network. According to an embodiment, the external electronic device 804 or the server 808 may be included in the second network 899. The electronic device 801 may be applied to intelligent services (e.g., smart home, smart city, smart car, or healthcare) based on 5G communication technology or IoT-related technology.

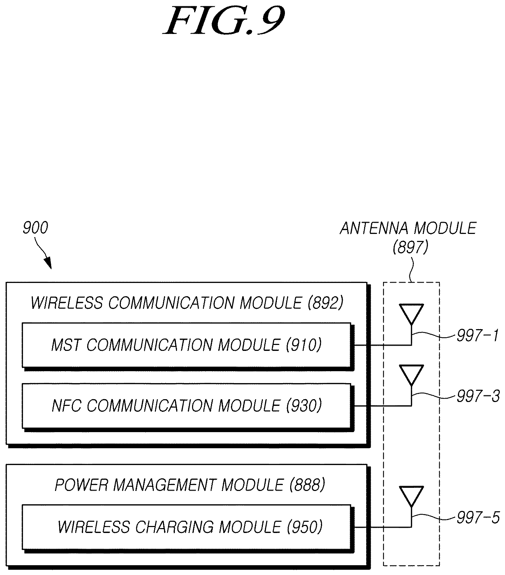

FIG. 9 is a block diagram 900 illustrating the wireless communication module 892, the power management module 888, and the antenna module 897 of the electronic device 801 according to various embodiments. Referring to FIG. 9, the wireless communication module 892 may include a magnetic secure transmission (MST) communication module 910 or a near-field communication (NFC) module 930, and the power management module 888 may include a wireless charging module 950. In such a case, the antenna module 997 may include a plurality of antennas that include a MST antenna 997-1 connected with the MST communication module 910, a NFC antenna 997-3 connected with the NFC communication module 930, and a wireless charging antenna 997-5 connected with the wireless charging module 950. For ease of description, the same components as those described in regard to FIG. 8 are briefly described or omitted from the description.

The MST communication module 910 may receive a signal containing control information or payment information such as card information from the processor 820, generate a magnetic signal corresponding to the received signal, and then transfer the generated magnetic signal to the external electronic device 802 (e.g., a point-of-sale (POS) device) via the MST antenna 997-1. To generate the magnetic signal, according to an embodiment, the MST communication module 910 may include a switching module (not shown) that includes one or more switches connected with the MST antenna 997-1, and control the switching module to change the direction of voltage or current supplied to the MST antenna 997-1 according to the received signal. The change of the direction of the voltage or current allows the direction of the magnetic signal (e.g., a magnetic field) emitted from the MST antenna 997-1 to change accordingly. If detected at the external electronic device 802, the magnetic signal with its direction changing may cause an effect (e.g., a waveform) similar to that of a magnetic field that is generated when a magnetic card corresponding to the card information associated with the received signal is swiped through a card reader of the electronic device 802. According to an embodiment, for example, payment-related information and a control signal that are received by the electronic device 802 in the form of the magnetic signal may be further transmitted to an external server 808 (e.g., a payment server) via the network 899.

The NFC communication module 930 may obtain a signal containing control information or payment information such as card information from the processor 820 and transmit the obtained signal to the external electronic device 802 via the NFC antenna 997-3. According to an embodiment, the NFC communication module 930 may receive such a signal transmitted from the external electronic device 802 via the NFC antenna 997-3.

The wireless charging module 950 may wirelessly transmit power to the external electronic device 802 (e.g., a cellular phone or wearable device) via the wireless charging antenna 997-5, or wirelessly receive power from the external electronic device 802 (e.g., a wireless charging device). The wireless charging module 950 may support one or more of various wireless charging schemes including, for example, a magnetic resonance scheme or a magnetic induction scheme.

According to an embodiment, some of the MST antenna 997-1, the NFC antenna 997-3, or the wireless charging antenna 997-5 may share at least part of their radiators. For example, the radiator of the MST antenna 997-1 may be used as the radiator of the NFC antenna 997-3 or the wireless charging antenna 997-5, or vice versa. In such a case, the antenna module 997 may include a switching circuit (not shown) adapted to selectively connect (e.g., close) or disconnect (e.g. open) at least part of the antennas 997-1, 997-3, or 997-5, for example, under the control of the wireless communication module 892 (e.g., the MST communication module 910 or the NFC communication module 930) or the power management module (e.g., the wireless charging module 950). For example, when the electronic device 801 uses a wireless charging function, the NFC communication module 930 or the wireless charging module 950 may control the switching circuit to temporarily disconnect at least one portion of the radiators shared by the NFC antenna 997-3 and the wireless charging antenna 997-5 from the NFC antenna 997-3 and to connect the at least one portion of the radiators with the wireless charging antenna 997-5.

According to an embodiment, at least one function of the MST communication module 910, the NFC communication module 930, or the wireless charging module 950 may be controlled by an external processor (e.g., the processor 820). According to an embodiment, at least one specified function (e.g., a payment function) of the MST communication module 910 or the NFC communication module 930 may be performed in a trusted execution environment (TEE). According to an embodiment, the TEE may form an execution environment in which, for example, at least some designated area of the memory 830 is allocated to be used for performing a function (e.g., a financial transaction or personal information-related function) that requires a relatively high level of security. In such a case, access to the at least some designated area of the memory 130 may be restrictively permitted, for example, according to an entity accessing thereto or an application being executed in the TEE.

The electronic device according to various example embodiments may be one of various types of electronic devices. The electronic devices may include, for example, a portable communication device (e.g., a smartphone), a computer device, a portable multimedia device, a portable medical device, a camera, a wearable device, or a home appliance. According to an example embodiment, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via at least a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC). Thus, each "module" herein may comprise circuitry.

Various embodiments as set forth herein may be implemented as software (e.g., the program 840) including one or more instructions that are stored in a storage medium (e.g., internal memory 836 or external memory 838) that is readable by a machine (e.g., the electronic device 801). For example, a processor (e.g., the processor 820) of the machine (e.g., the electronic device 801) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various example embodiments may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

According to an example embodiment, an electronic device may comprise a printed circuit board layer including a plurality of flexible areas and a plurality of rigid areas, a wireless charging circuit disposed in one rigid area among the plurality of rigid areas, and a plurality of wireless charging antennas disposed in the plurality of flexible areas and having a coil shape. The plurality of wireless charging antennas each may be electrically connected (directly or indirectly) in parallel with the wireless charging circuit.

In an embodiment, the plurality of flexible areas each may include a fill-cut area obtained by fill-cutting a portion thereof. The plurality of wireless charging antennas may be disposed in the fill-cut area.

In an embodiment, the electronic device may further comprise at least two flexible printed circuit board (FPCB) layers. The plurality of flexible areas may be formed as partial areas of the at least two FPCB layers.

In an embodiment, the plurality of wireless charging antennas each may be connected in parallel with the wireless charging circuit through a first line and a second line. The first line and the second line may be formed over the at least two FPCB layers.

In an embodiment, the electronic device may further comprise at least one via. The at least one via may be formed to pass through the at least two FPCB layers.

In an embodiment, at least one of the first line and the second line may be connected with the wireless charging circuit through the at least one via.

In an embodiment, the plurality of rigid areas may include a first rigid area including a rigid area formed first from a first end of the electronic device, a second rigid area including a rigid area formed second from the first end of the electronic device, and a third rigid area formed third from the first end of the electronic device. The wireless charging circuit may be disposed in the third rigid area.

In an embodiment, the plurality of rigid areas may include a first rigid area including a rigid area formed first from a first end of the electronic device, a second rigid area including a rigid area formed second from the first end of the electronic device, and a third rigid area formed third from the first end of the electronic device. The wireless charging circuit may be disposed in the second rigid area.

In an embodiment, at least one of the plurality of wireless charging antennas may be disposed to have a predetermined slope with respect to the first line and the second line.

In an embodiment, the electronic device may further comprise a matching circuit formed in each of the plurality of rigid areas. The first line and the second line may be connected with the wireless charging circuit through at least the matching circuit.

In an embodiment, lengths of the first line and the second line of each of the plurality of wireless charging antennas may be formed within a predetermined range.

In an embodiment, the first line and the second line may be disposed to pass through the plurality of rigid areas. A shielding area may be formed around an area passed through by the first line and the second line, in the plurality of rigid areas.

In an embodiment, the electronic device may further comprise a battery and a connection member connecting the battery and the at least two FPCB layers.

In an embodiment, the plurality of wireless charging antennas may receive an electrical signal from a plurality of wireless transmission antennas of an external device. The electrical signal may be transferred to the battery through the first line and the second line.

In an embodiment, the electronic device may further comprise a plurality of other flexible areas and a plurality of other rigid areas formed in a direction opposite to a direction in which the flexible areas are formed on the at least two FPCB layers. At least one component to allow the electronic device to operate based on a radio frequency (RF) frequency may be disposed in at least one of the plurality of other rigid areas.

Each embodiment herein may be used in combination with any other embodiment(s) described herein.

While the disclosure has been illustrated and described with reference to various embodiments, it will be understood that the various embodiments are intended to be illustrative, not limiting. It will further be understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. An electronic device comprising:
a printed circuit board layer including a plurality of flexible areas and a plurality of rigid areas;
a wireless charging circuit disposed in a rigid area among the plurality of rigid areas; and
a plurality of wireless charging antennas disposed in the plurality of flexible areas, respectively, and each of the wireless charging antennas comprising a coil shape,
wherein the plurality of wireless charging antennas each are electrically connected in parallel with the wireless charging circuit.

2. The electronic device of claim 1, wherein the plurality of flexible areas each include a fill-cut area obtained by fill-cutting a portion thereof, and
wherein the plurality of wireless charging antennas are disposed at least partially in respective fill-cut areas.

3. The electronic device of claim 1, further comprising at least two flexible printed circuit board (FPCB) layers,
wherein the plurality of flexible areas are formed as partial areas of the at least two FPCB layers.

4. The electronic device of claim 3, wherein the plurality of wireless charging antennas each are connected in parallel with the wireless charging circuit through at least a first line and a second line, and
wherein the first line and the second line are formed over the at least two FPCB layers.

5. The electronic device of claim 4, further comprising at least one conductive via, wherein the at least one via is formed to pass through the at least two FPCB layers.

6. The electronic device of claim 5, wherein at least one of the first line and the second line is connected with the wireless charging circuit through the at least one via.

7. The electronic device of claim 4, wherein the plurality of rigid areas include a first rigid area including a rigid area formed first from a first end of the electronic device, a second rigid area including a rigid area formed second from the first end of the electronic device, and a third rigid area formed third from the first end of the electronic device, and
wherein the wireless charging circuit is at least partially disposed in the third rigid area.

8. The electronic device of claim 4, wherein the plurality of rigid areas include a first rigid area including a rigid area formed first from a first end of the electronic device, a second rigid area including a rigid area formed second from the first end of the electronic device, and a third rigid area formed third from the first end of the electronic device, and
wherein the wireless charging circuit is disposed in the second rigid area.

9. The electronic device of claim 8, wherein at least one of the plurality of wireless charging antennas is disposed to have a predetermined slope with respect to the first line and the second line.

10. The electronic device of claim 8, further comprising a matching circuit in each of the plurality of rigid areas,
wherein the first line and the second line are connected with the wireless charging circuit through at least the matching circuit.

11. The electronic device of claim 8, wherein lengths of the first line and the second line of each of the plurality of wireless charging antennas are within a predetermined range.

12. The electronic device of claim 4, wherein the first line and the second line pass through the plurality of rigid areas, and
wherein a shielding area is formed around an area passed through by the first line and the second line, in the plurality of rigid areas.

13. The electronic device of claim 4, further comprising:
a battery; and
a connector for connecting the battery and the at least two FPCB layers.

14. The electronic device of claim 13, wherein the plurality of wireless charging antennas are configured to receive an electrical signal from a plurality of wireless transmission antennas of an external device, and
wherein the electrical signal is to be transferred to the battery through at least the first line and the second line.

15. The electronic device of claim 3, further comprising a plurality of other flexible areas and a plurality of other rigid areas formed in a direction opposite to a direction in which the flexible areas are formed on the at least two FPCB layers,
wherein at least one electrical component to allow the electronic device to operate based on a radio frequency (RF) frequency is disposed in at least one of the plurality of other rigid areas.
